# FASCICULE DE BREVET EUROPEEN

(11) **EP 2 532 026 B1**
(45) Date de publication et mention de la délivrance du brevet: **18.02.2015**
(21) Numéro de dépôt: 11701151.0
(22) Date de dépôt: 31.01.2011
(51) Int. Cl.: F28D 15/00, H01L 23/473

(54) **ECHANGEUR DE CHALEUR NOTAMMENT POUR UN SEMI-CONDUCTEUR DE PUISSANCE**
WÄRMETAUSCHER, INSBESONDERE FÜR EINEN LEISTUNGSHALBLEITER
HEAT EXCHANGER, NOTABLY FOR A POWER SEMICONDUCTOR

(30) Priorité: 01.02.2010 FR 1050681
(43) Date de publication de la demande: 12.12.2012
(73) Titulaire: ALSTOM Technology Ltd, 5400 Baden (CH)
(72) Inventeur: NICOLAS, Claude, F-77430 Champagne Sur Seine (FR)
(74) Mandataire: Ilgart, Jean-Christophe
(86) Numéro de dépôt international: PCT/EP2011/051285
(87) Numéro de publication internationale: WO 2011/092322

(56) Documents cités:
- EP-A1- 0 613 179
- US-A1- 2007 256 810
- US-A1- 2009 032 937

## Description

Le sujet de l'invention est un échangeur de chaleur, ainsi qu'un agencement l'employant, notamment un réseau de transistors de puissance.

Certains transistors de puissance dissipent une énergie calorifique si importante qu'un refroidissement est nécessaire. Les échangeurs de chaleur existants sont nombreux, mais leur rigidité rend souvent difficile de les appliquer avec un ajustement de contact suffisant contre un tel organe dissipateur de chaleur qui peut s'étendre sur une surface irrégulière. On doit aussi reconnaître que beaucoup n'ont pas une bonne capacité ou une bonne uniformité d'enlèvement de la chaleur sur leur surface. Enfin, certains sont sujets à des pertes de charge importantes du fluide de refroidissement.

On citera en passant les modèles composés d'un réseau d'ailettes, généralement destinés aux refroidissements par air, sans circulation d'un fluide particulier, et qui sont insuffisants pour l'application principale envisagée. Un autre genre d'échangeurs de chaleur comprend des plaques internes en spirales imposant un écoulement en tourbillon au fluide d'échange de chaleur, l'élément à refroidir étant placé sur une face latérale du boîtier, à un bord de l'écoulement. Le brevet EP - A - 0 613 179 décrit une telle conception, qui possède une bonne uniformité de refroidissement, mais des pertes de charge importantes et une rigidité trop grande, toutes les plaques internes s'appuyant sur l'élément à refroidir.

Une autre conception repose sur l'emploi de plaques ondulées internes délimitant des canaux de refroidissement. Dans la réalisation particulière du document EP - A - 1 898 464, tout en parcourant les ondulations selon leur longueur, le fluide d'échange de chaleur est amené à s'approcher de la surface d'échange de chaleur puis à s'en éloigner par des ailettes obliques : son mouvement d'ensemble est sinueux dans les canaux. Ces échangeurs ont encore, en général, une rigidité importante, l'uniformité de la température de refroidissement n'est pas très bonne, et les performances d'enlèvement de chaleur sont parfois insuffisantes.

L'invention est relative à un échangeur de chaleur perfectionné, dépourvu des inconvénients précédents et qui possède notamment une bonne souplesse lui permettant d'être appliqué sur un organe à refroidir de forme irrégulière, et en même temps une résistante suffisante pour tenir à la pression d'application souhaitée, d'excellentes performances d'enlèvement de la chaleur et d'uniformité de température, et des pertes de charge modérées pour le fluide.

Sous une forme générale, l'invention est relative à un échangeur de chaleur comprenant : un boîtier composé d'une face inférieure, d'une face supérieure et d'une face périphérique ; un réseau de tubes parallèles s'étendant dans le boîtier de la face supérieure à la face inférieure ; une plaque intermédiaire à la face inférieure et à la face supérieure, s'étendant jusqu'à la face périphérique et divisant l'intérieur du boîtier en une chambre inférieure et une chambre supérieure ; des conduits d'entrée et de sortie de fluide de refroidissement débouchant respectivement dans la chambre supérieure et la chambre inférieure, les tubes s'étendant à travers la plaque intermédiaire et débouchant dans la chambre inférieure et la chambre supérieure.

Elle est aussi relative à un agencement comprenant un organe dissipateur de chaleur, au moins un tel échangeur de chaleur dont la face inférieure est posée contre l'organe dissipateur de chaleur, et une presse dont un plateau presse l'organe dissipateur de chaleur vers l'échangeur de chaleur.

L'invention sera maintenant décrite plus en détail en liaison aux figures suivantes, décrivant une réalisation purement illustrative de l'invention :
- la figure 1 représente un agencement complet, en coupe centrale,
- la figure 2, un échangeur de chaleur en vue de dessus,
- la figure 3, l'intérieur d'un échangeur,
- la figure 4, le pressage de l'agencement,
- la figure 5, un tube particulier,
- et les figures 6 et 7, deux réalisations d'inserts d'autres tubes particuliers.

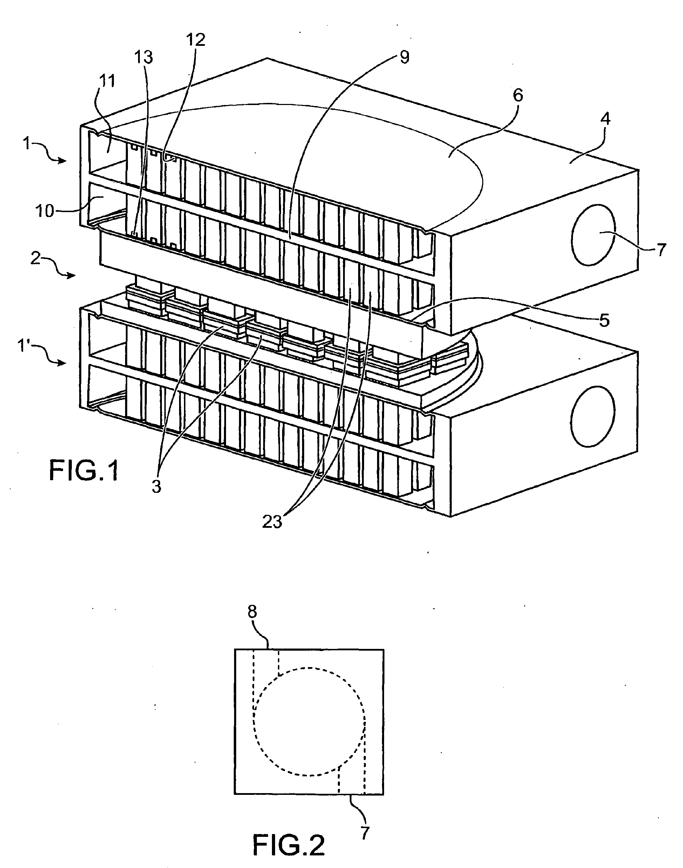

La figure 1 représente un agencement conforme à l'invention, avec deux échangeurs de chaleur (1 et 1') disposés de part et d'autre d'un réseau (2) plan de transistors (3) de puissance. L'agencement est à peu près symétrique, et les échangeurs de chaleur (1 et 1') peuvent être semblables. La description portera donc surtout sur l'échangeur de chaleur (1). Il comprend un boîtier composé d'une face périphérique (4) épaisse et rigide, d'une face inférieure (5) dirigée vers les transistors (3) et d'une face supérieure (6) opposée à la précédente, et plane comme elle. La face inférieure (5) sert à l'échange de chaleur, et la face supérieure (6) au pressage de l'échangeur de chaleur (1). Toutes ces faces délimitent un volume clos à l'exception d'un perçage d'entrée (7) et d'un perçage de sortie (8) opposés l'un à l'autre et représentés à la figure 2. La face inférieure (5) et la face supérieure (6) sont souples, c'est-à-dire aptes à se déformer pour épouser le relief de pièces pressées sur elles.

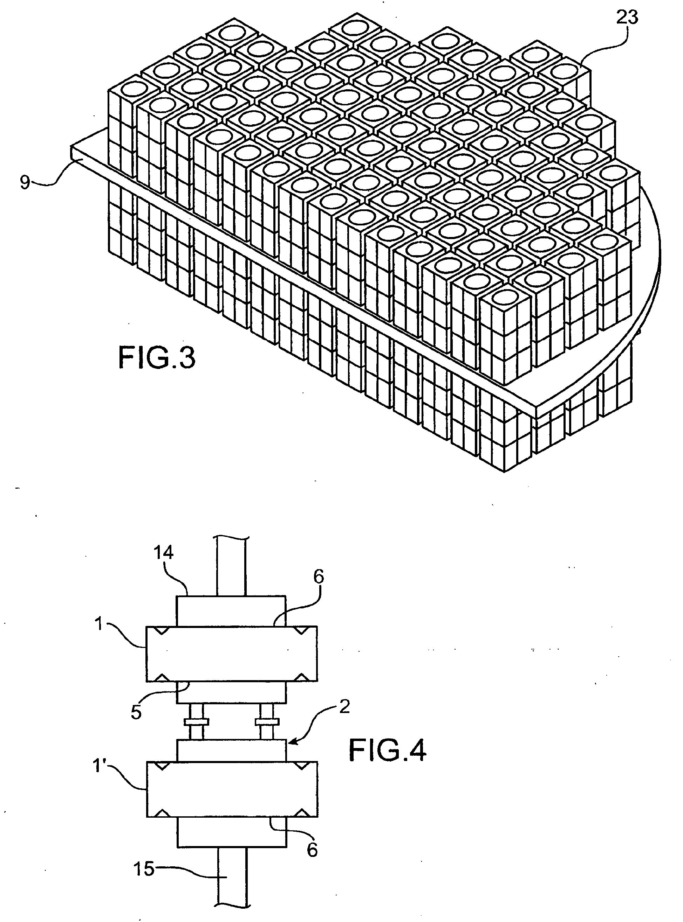

L'intérieur du boîtier comprend une plaque intermédiaire (9) s'étendant dans toutes les directions jusqu'à la plaque périphérique (4) et divisant l'intérieur du boîtier en une chambre inférieure (10) et une chambre supérieure (11) donnant respectivement sur la face inférieure (5) et la face supérieure (6). Il contient encore un réseau de tubes (23), mieux visibles à la figure 3, s'étendant depuis la face inférieure (5) jusqu'à la face supérieure (6), brasés à elles, et sertis dans la plaque intermédiaire (9) ou autrement fixés à elle. Les tubes (23) s'étendent en un réseau serré dans au moins la plus grande partie de l'intérieur du boîtier. La plaque intermédiaire (9) est plus fine que la face périphérique (4) et moins que les faces inférieure (5) et supérieure (6).

L'écoulement du fluide d'enlèvement de chaleur dans l'échangeur (1) est comme suit. Le fluide entre par le perçage d'entrée (7) dans la chambre supérieure (11) puis s'infiltre dans les tubes (23) par des canaux (12) présents entre eux et la face supérieure (6), dans des parties non brasées de la jonction. Il parcourt les tubes (23) à travers la plaque intermédiaire (9) et ressort dans la chambre inférieure (10) en passant par des canaux (13) présents entre les tubes (23) et la face inférieure (5). Il se répand dans la chambre inférieure (10) avant de la quitter par le perçage de sortie (8). Tout le fluide mis en circulation arrive donc sur la face inférieure (5) affectée à l'échange de chaleur et participe à celui-ci, ce qui donne une bonne performance d'enlèvement de la chaleur. La perte de charge reste modérée grâce à la longueur relativement faible du trajet d'écoulement, au petit nombre d'obstacles et de changements de direction et à l'abondance des tubes (23). Les tubes (23) étant serrés et parcourus de débits à peu près égaux d'un fluide provenant d'une même chambre supérieure (11), l'enlèvement de chaleur est à peu près uniforme sur toute la superficie de la face inférieure (5), et la température y est donc à peu près uniforme. Enfin, la souplesse des faces inférieure (5) et supérieure (6) et même de la plaque intermédiaire (9), permet d'exercer un contact continu contre le réseau (2) par un pressage originaire de la face supérieure (6), les tubes (23) possédant toutefois une rigidité suffisante pour empêcher l'écrasement de l'échangeur (1) et pour bien transmettre l'effort de pressage sur un réseau (2).

Le pressage de l'agencement est représenté à la figure 4. Un plateau (14) d'une presse pousse sur la face supérieure (6) de l'échangeur de chaleur (1), et un plateau opposé (15) de la même presse pousse sur la même face de l'échangeur de chaleur (1'), vers le réseau (2).

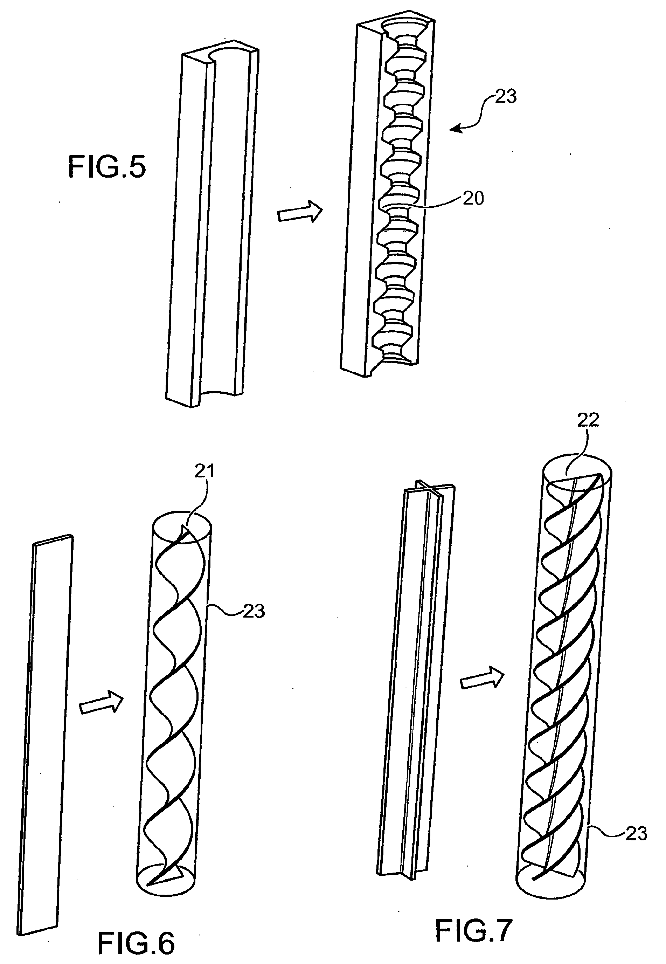

Les tubes (23) peuvent être lisses ; ils peuvent aussi avoir une forme spéciale, par exemple, en les pourvoyant de rainures hélicoïdales (20) à leur face interne (figure 5) ou en y insérant des vrilles (21 ou 22), obtenues en tordant un profilé plat ou en croisillon (figures 6 et 7). Tous ces éléments améliorent la régularité de l'écoulement dans les tubes (23), tout en accroissant la superficie d'échange de chaleur (surtout les inserts), et donc la performance d'enlèvement de chaleur.

## Revendications

1. Echangeur de chaleur comprenant un boîtier composé d'une face inférieure (5), d'une face supérieure (6) et d'une face périphérique (4), un réseau de tubes (23) parallèles s'étendant dans le boîtier de la face supérieure (6) à la face inférieure (5), une plaque intermédiaire (9) à la face inférieure et à la face supérieure, s'étendant jusqu'à la face périphérique et divisant l'intérieur du boîtier en une chambre inférieure (10) et une chambre supérieure (11), des conduits d'entrée (7) et de sortie (8) de liquide de refroidissement débouchant respectivement dans la chambre supérieure (11) et la chambre inférieure (10), les tubes (23) s'étendant à travers la plaque intermédiaire et débouchant par des canaux (12, 13) dans la chambre inférieure et la chambre supérieure.

2. Echangeur de chaleur selon la revendication 1, **caractérisé en ce que** les tubes (23) sont fixés dans la plaque intermédiaire (9), sur la face inférieure (5) et la face supérieure (6), qui sont plus fines que la face périphérique (4) et la plaque intermédiaire (9).

3. Echangeur de chaleur selon l'une quelconque des revendications 1 ou 2, **caractérisé en ce que** les tubes (23) sont pourvus de cannelures hélicoïdales (20) à leur face interne.

4. Echangeur de chaleur selon l'une quelconque des revendications 1 ou 2, **caractérisé en ce que** les tubes (23) contiennent des inserts hélicoïdaux (21, 22).

## Patentansprüche

1. Wärmetauscher, umfassend ein Gehäuse mit einer Unterseite (5), einer Oberseite (6) und einer Umfangsseite (4), ferner mit einem Netz aus parallelen Rohren (23), die sich in dem Gehäuse von der Oberseite (6) zu der Unterseite (5) erstrecken, des weiteren mit einer Zwischenplatte (9) zwischen der Unterseite und der Oberseite, die sich bis zu der Umfangsseite erstreckt und das Innere des Gehäuses in eine untere Kammer (10) und eine obere Kammer (11) unterteilt, wobei Eintrittsleitungen (7) und Austrittsleitungen (8) für flüssiges Kühlmittel in die obere Kammer (11) bzw. die untere Kammer (10) münden, und sich die Rohre (23) quer zu der Zwischenplatte erstrecken und über Kanäle (12, 13) in die untere Kammer und die obere Kammer münden.

2. Wärmetauscher nach Anspruch 1, **dadurch gekennzeichnet, daß** die Rohre (23) in der Zwischenplatte (9) über der Unterseite (5) und der Oberseite (6) befestigt sind, die dünner sind als die Umfangsseite (4) und die Zwischenplatte (9).

3. Wärmetauscher nach den Ansprüchen 1 oder 2, **dadurch gekennzeichnet, daß** die Rohre (23) auf ihrer Innenseite mit schraubenförmigen Rinnen (20) versehen sind.

4. Wärmetauscher (1) nach den Ansprüchen 1 oder 2, **dadurch gekennzeichnet, daß** die Rohre (23) schraubenförmige Einsätze (21, 22) enthalten.

## Claims

1. A heat exchanger, comprising: a casing made up of a bottom face (5), a top face (6), and a peripheral face (4); an array of parallel tubes (23) extending inside the casing from the top face (6) to the bottom face (5); an intermediate plate (9) between the bottom face and the top face, extending to the peripheral face and dividing the inside of the casing into a bottom chamber (10) and a top chamber (11); and entry and exit ducts (7, 8) for cooling fluid opening out respectively into the top chamber (11) and the bottom chamber (10); the tubes (23) extending through the intermediate plate and opening out into channels (12, 13) in the bottom chamber and the top chamber.

2. A heat exchanger according to claim 1, **characterized in that** the tubes (23) are fastened inside the intermediate plate (9), to the bottom face (5) and to the top face (6), which faces are thinner than the peripheral face (4) and the intermediate plate (9).

3. A heat exchanger according to claim 1 or claim 2, **characterized in that** the tubes (23) are provided with helical (20) fluting on their inside faces.

4. A heat exchanger according to claim 1 or claim 2, **characterized in that** the tubes (23) contain helical inserts (21, 22).
